Europäisches Patentamt

European Patent Office

Office européen des brevets

(11) Publication number: **0 066 860**
A2

(12) **EUROPEAN PATENT APPLICATION**

(21) Application number: **82104911.1**

(22) Date of filing: **04.06.82**

(51) Int. Cl.³: **H 01 J 61/52**

(30) Priority: **04.06.81 US 270294**

(43) Date of publication of application: **15.12.82**
Bulletin 82/50

(84) Designated Contracting States: **DE FR GB IT NL**

(71) Applicant: **GENERAL ELECTRIC COMPANY, 1 River Road, Schenectady New York 12305 (US)**

(72) Inventor: **Johnson, Peter Dexter, 1100 Merlin Drive, Schenectady, New York 12309 (US)**

(74) Representative: **Voigt, Reinhard, Dipl.-Ing. et al, Kaiserstrasse 41, D-6000 Frankfurt (Main) 1 (DE)**

(54) **A temperature-controlled, metal-vapor discharge lamp.**

(57) A lamp which is particularly useful in supplying high intensity ultraviolet radiation for use in the manufacture of large-scale integrated circuit chips employs means to controllably heat the end portions so as to maintain the lamp at optimally efficient temperatures. Furthermore, the lamp of the present invention employs heat insulating means surrounding a portion of the lamp discharge so as to maintain the envelope wall temperatures at sufficiently high temperatures to prevent condensation of the discharge medium or other materials thereon.

## A Temperature-Controlled, Metal-Vapor Discharge Lamp

This invention relates to discharge lamps and, more particularly, to metal vapor discharge lamps having temperature control means.

In order to obtain desired spectral characteristics, metal vapor discharge lamps must be operated with metal vapor at pressures corresponding to the vapor pressure over a reservoir of the metal held at an elevated temperature. This requires that the entire interior of the lamp be maintained at or above the reservoir temperature to avoid reduction of the vapor pressure due to condensation of the metal vapor at the coolest points within the lamp. For certain metal vapors used as the discharge medium, the reservoir temperature must be controlled to within 10 to 20°C of the optimum in order to maximize the desired spectral output. Such discharge arc media include metals such as the alkali metals or the metals of group IIb of the periodic table, namely, zinc, cadmium and mercury. For metals such as the alkali metals or group IIb metals, the reservoir temperatures required range from approximately 90°C to approximately 400°C. See, for example, the article titled, "Excitation of $Hg^+1942\overset{\bullet}{A}$ in the High-Current, Low-Pressure Discharge", volume 18, pg. 381 of Applied Physics Letters (1971), by the instant inventor and the article titled, "Mercury Resonance Radiation in the High-Current, Low-Pressure Discharge", in volume 61, page 1,451 of the Journal of the Optical Society of America (1971), by the instant inventor, and the article titled, "Intensity of the Low-Pressure, High-Current Cadmium Vapor Discharge in the Middle Ultraviolet", in volume 49, page 553 of the _Journal of Applied Physics_ (1978), also by the same inventor as herein.

In prior art lamps, the required reservoir temperature has been maintained by two other forms of lamp construction. The first is typified by the high pressure mercury and sodium lamps in which the arc tube is operated at a very high wall loading. The term "high wall loading" means that the electrical power supplied to the lamp for each square unit of arc tube wall area is high. In these lamps, the proper temperature is attained by a suitable balance of power input to power output with only minor heat balancing or conserving means.

Another type of lamp construction for reservoir temperature control is typified by the low pressure sodium lamp. Such lamps are described, for example, in U.S. Patent No. 3,657,590, issued to the same inventor as herein. In this type of lamp, simply containing the discharge tube within an evacuated jacket is sufficient for temperature control for lamps having intermediate power densities. However, neither of these configurations permit precise control of temperature and vapor pressure which, as indicated above, is desirable to attain the maximum useful radiative output from the lamp. The high intensity discharge (HID) configuration results in too high a vapor pressure in the discharge. In low power density lamps, the use of a seprate jacket is difficult and expensive to construct since it requires complicated support structures for the discharge tube and sealed-in leads to conduct current to the electrodes. In addition, where the desired spectral output is in the ultraviolet or infrared range, special

2

spectrally-transmissive materials such as fused quartz are required. Moreover, the large size of the outer jacket that is required often renders such lamp designs economically prohibitive. In other cases, such as in sources operating in the far ultraviolet range, the required quality of light-transmissive material is not available in the sizes needed.

## Summary of the Invention

In accordance with a preferred embodiment of the present invention, a discharge lamp comprises an evacuable light transmissive envelope with end portions and a middle portion; an ionizable discharge medium disposed within the envelope; electrode means disposed within the envelope end portions; means for controllably heating the end portions; and means for insulating the middle portion against heat loss. The discharge lamp of the present invention is characterized by the fact that the desired operating temperature of the lamp is attained in the main part of the discharge column by heat from the discharge itself which is retained by having an integrally attached vacuum jacket surrounding the discharge column. This temperature is preferably slightly above that of the temperature within the electrode chambers which are heated, for example, by separate coils or ovens. The reservoir temperature is the temperature of the electrode chamber which can be accurately controlled by adjusting the power supplied to the heating means. The light-transmissive envelope and insulating enclosure are preferably transmissive to electromagnetic radiation having a wavelength longer than approximately 180 nanometers. The ionizable medium is preferably a vaporizable metal such as mercury, zinc and cadmium, halides thereof and mixtures of metals and/or their halides. Other media may also be employed.

3

Accordingly, it is an object of the present invention to provide a metal vapor lamp having a high degree of temperature control.

It is also an object of the present invention to provide an intense ultraviolet source such as those useful in photo-lithography for the manufacture of large-scale integrated circuits.

## Description of the Figures

The subject matter which is regarded as the invention is particularly pointed out and distinctly claimed in the concluding portion of the specification. The invention, however, both as to organization and method of practice, together with further objects and advantages thereof, may best be understood by references to the following description taken in connection with the accompanying drawing in which:

FIGURE 1 is a partial cross-sectional side elevation view illustrating a preferred embodiment of the discharge lamp of the present invention;

FIGURE 2 is similar to FIGURE 1 except that the heating means in envelope ends are disposed perpendicularly to the middle portion of the discharge tube.

## Detailed Description of the Invention

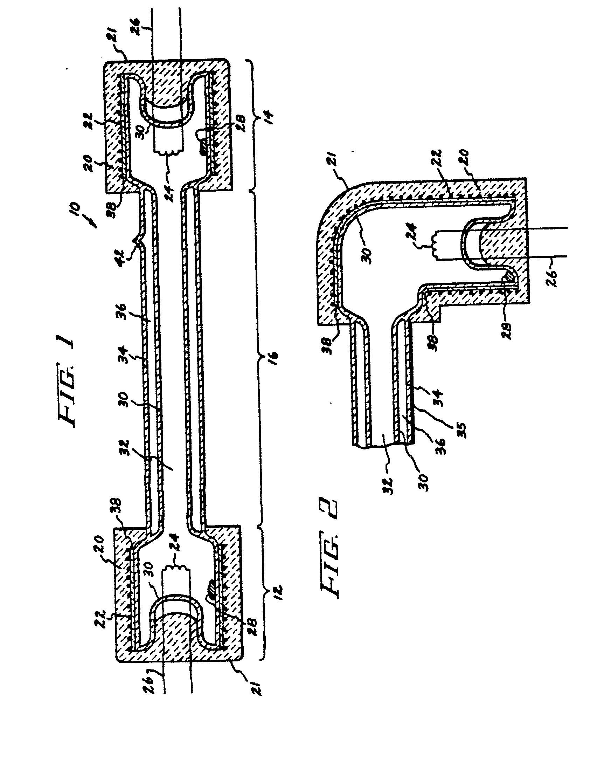

FIGURE 1 illustrates the temperature-controlled discharge lamp 10 of the present invention. The lamp comprises discharge tube 30 having a middle portion 16 and end portions 12 and 14. The end portions are preferably somewhat larger in diameter than the middle portion and serve as a reservoir for the vaporizable metal or metal halide discharge medium. The vaporizable discharge medium may be deposited in the tube in the form of droplets or blobs 28. Also disposed within the end

4

portions 12 and 14 are electrodes 24 with leads 26 extending through the envelope. Once vaporized the discharge takes place in the ionizable medium along discharge column 32.

Two significant features of the present invention are the heating elements or ovens disposed about the end portions of the envelope 30 and insulating jacket 34 disposed about the middle of the discharge envelope 30. In particular, heating means typically comprise a heating element 22 coiled about refractory mat 38. Additionally, refractory fiber fill material 20 is packed around coil 22 to insulate the end portions of the lamp. Containment cup 21 provides a rigid holding structure for insulating fiber 20. Other heating element structures may also be provided for the lamp end portions 12 such as a coil integrally contained within a solid ceramic structure which may be removed as one piece.

To maintain the proper temperature for the main discharge column an insulating, but light-transmissive, envelope 34 is also provided around the middle portion of the discharge tube. Additionally, a vacuum 36 is preferably maintained between the inner and outer walls of the lamp configuration. The prevention of a significant amount of heat loss through the middle portion acts to maintain the discharge at a temperature which prevents condensation of discharge medium components on the walls thereof. Furthermore, precise control of the reservoir temperature results in a highly-efficient and, in many cases, an optimum level of radiation output. In some cases, the lamp of the present invention acts to provide over 100 times the efficiency of ultraviolet radiation previously achievable in certain spectral regions.

FIGURE 1 is an overall view of the lamp showing the elec-

5

trode chambers in a coaxial configuration with the main discharge column. In contrast, FIGURE 2 shows an alternative
configuration in which the electrode chambers are perpendicular to the axis of the main discharge column. Such variations
in configuration do not effect the operation or the efficacy
of the lamp of the present invention.

The heating coil 22 and the exposed end portion of discharge envelope 30 is covered with an insulating material such
as glass fiber 38, which is held in place by a glass or ceramic cup 20. This heating element design is typical of a member of various designs which are suitable. The vaporizable
metal 28 is preferably divided between the end portions 12 and
14.

For a lamp operating in the far ultraviolet region, using
cadmium as a radiating species, the lamp is dimensioned approximately as follows. The inner diamter of the discharge
tube 30 in the middle portion 16 is preferably between approximately 8 and 10 millimeters in diameter, if zinc, cadmium or
mercury are employed, although this diameter may be as large
as 20 or as small as 5 millimeters. The inside diameter of
the outer insulating jacket 34 is preferably about 10 millimeters larger than the outside diameter of the inner portion of
the discharge tube, although the range of approximately 5 to
approximately 20 millimeters larger, is also useful. The
length of the central portion 16 may be as short as 10 centimeters, or longer than 100 centimeters, depending upon the
application. If the discharge tube and insulating jacket are
fused quartz, as is desirable for ultraviolet lamps, graded
glass sealing means, which are conventionally used in the art,
are employed to effect a transition from fused quartz to

6

softer glass through which the leads 26 pass.

The ovens or heating coils of FIGURE 1 may be made removable. On the other hand, FIGURE 2 illustrates an alternative embodiment in which the heating means is not removable but in which the electrode chambers are oriented relatively perpendicularly to the central discharge column in order to conserve space. In this embodiment, heating coil 22 is attached in a zig-zag pattern in the region of the bend. The heating coils may be supplied with power from separate transformers or may even be operated in series with the discharge.

In the cadmium vapor lamp, the desired reservoir temperature is between approximately 260°C and 290°C in order to generate ultraviolet radiation at 214, 227 and 229 nanometers. The current to the heating coils is controllably adjusted to provide this temperature. With a 9 millimeter inside diameter arc tube 30, the arc discharge heats the middle portion to a temperature higher than the electrode chambers. In the above-described cadmium vapor lamp, the electrodes are 1.5 amp fluorescent lamp electrodes and a fluorescent lamp ballast is used to operate the lamp. Such a lamp is particularly useful in producing semiconductor photoresist patterns for the production of large-scale integrated circuits.

Although the preferred embodiment of the present invention is a far ultraviolet lamp source with cadmium as the radiating species, other discharge material may be employed including metals in groups I, IIa, IIIb, Va, VIa of the periodic table and their vaporizable compounds easily. In particular, in group Va, arsenic and antimony may be employed and in group VIa, selenium and tellurium may be employed. For the lamp employing a cadmium metal vapor discharge medium, the intensity

7

efficiency of ultraviolet radiation produced is 100 times that conventionally obtained. This is due to the construction of the present invention which maintains the reservoir temperature at a level between 10°C and 20°C of the optimum in order to maximize the desired spectral output. In general, the reservoir temperature range for the materials listed, is between approximately 100°C and 400°C or more.

From the above it may be appreciated that the present invention is particularly valuable for use as a source of far ultraviolet length radiation and, furthermore, that it is particularly useful in the manufacture of semiconductors such as those created by photolithography in large-scale integrated circuit chips. Such ultraviolet lamps may also be employed in photochemistry and sterilization applications. The present invention is also useful in providing lamps producing electromagnetic radiation at near optimal spectral output intensities because of the lamp configuration. In particular, heating means at the end portions of the discharge envelope maintain the reservoir of vaporizable metal at near optimal temperatures and the insulating jacket in the middle portion of the lamp further operates to maintain the discharge column at an appropriate temperature so that the discharge species are not permitted to condense upon the tube wall. Furthermore, the tube may be coated, particularly along the middle portion thereof, with reflecting material 35 (in FIGURE 2) to further concentrate the optical output from the lamp. If such a reflector is employed, it is preferred that it be a separate structure from the lamp itself, though.

While the invention has been described in detail herein in accord with certain preferred embodiments thereof, many

8

RD-12,945
0066860

modifications and changes therein may be effected by those skilled in the art. Accordingly, it is intended by the appended claims to cover all such modifications and changes as fall within the true spirit and scope of the invention.

9

## C L A I M S

**The invention claimed is:**

1. A discharge lamp comprising:

an evacuable envelope having at least a portion thereof transmissive to electromagnetic radiation having wavelength larger than approximately 180 nanometers, said envelope having end portions and a middle portion;

an ionizable discharge medium disposed within said envelope;

electrode means disposed in said envelope end portions for causing electric current to flow through said discharge medium;

means for controllably heating said end portions; and means for insulating said middle portion against heat loss.

2. The lamp of claim 1 in which said ionizable medium is selected from the group consisting of mercury, zinc, cadmium, halides thereof, and mixtures of the foregoing.

3. The lamp of claim 1 in which said insulating means comprises a second evacuable envelope surrounding said middle portion.

4. The discharge lamp of claim 1 in which at least a part of said middle portion possesses a reflective means which act to reflect electromagnetic radiation having wavelengths greater than 180 nanometers.

5. The discharge lamp of claim 1 in which said heating means comprises a ceramic-encased heating element.

6. The lamp of claim 1 in which said heating means are removable from said envelope.

1

7.    The lamp of claim 1 in which said heating means acts to keep said end portions at a predetermined temperature between approximately 100°C and approximately 400°C.

8.    The discharge lamp of claim 1 in which said ionizable medium is selected from a group consisting of the vaporizable metals in groups I, IIa, IIIb, Va and VIa of the periodic table and their vaporizable compounds.

9.    The discharge lamp of claim 1 in which said end portions are coaxial with said middle portion.

10.    The discharge lamp of claim 1 in which said end portions are perpendicular to said middle portion.

LDC/kaa

- 2 -

FIG. 1

FIG. 2